(19) Europäisches Patentamt
European Patent Office
Office européen des brevets

(11) **EP 0 834 994 B1**

(12) **EUROPÄISCHE PATENTSCHRIFT**

(45) Veröffentlichungstag und Bekanntmachung des Hinweises auf die Patenterteilung:
**21.08.2002   Patentblatt 2002/34**

(51) Int Cl.$^7$: **H03L 1/02**

(21) Anmeldenummer: **97116690.5**

(22) Anmeldetag: **25.09.1997**

(54) **Schaltungsanordnung mit einem Oszillator**

Circuit arrangement comprising an oscillator

Montage de circuit comprenant un oscillateur

(84) Benannte Vertragsstaaten:
**DE FR GB IT NL**

(30) Priorität: **02.10.1996  DE 19640677**

(43) Veröffentlichungstag der Anmeldung:
**08.04.1998   Patentblatt 1998/15**

(73) Patentinhaber: **ROBERT BOSCH GMBH**
**70442 Stuttgart (DE)**

(72) Erfinder:
• **Tanneberger, Volkmar**
**31139 Hildesheim (DE)**
• **Bode, Friedrich-Wilhelm**
**31552 Apelern (DE)**

(56) Entgegenhaltungen:
WO-A-90/16113          WO-A-96/24986
DE-A- 4 209 843

• **PATENT ABSTRACTS OF JAPAN vol. 095, no. 001, 28.Februar 1995 & JP 06 291550 A (SEIKO EPSON CORP), 18.Oktober 1994,**

**Beschreibung**

Die Erfindung betrifft eine Schaltungsanordnung mit einem Mikroprozessor, einem Speicher und einem Oszillator zur Erzeugung eines Frequenzsignals hoher Genauigkeit sowie mit einer Empfangseinrichtung für ein eine genaue Referenzfrequenz enthaltendes Signal. Eine derartige Anordung ist z.B. aus WO-A-96 24 986 bekannt.

Durch die Einführung von Quarz-Oszillatoren ist es möglich geworden, für Massenprodukte Oszillatoren mit hoher Konstanz und Ganggenauigkeit zur Verfügung zu stellen.

Die Ausgangsfrequenz preiswerter Quarzoszillatoren ist allerdings etwas temperaturabhängig. Für manche Anwendungsfälle ist die im Einsatztemperaturbereich entstehende Frequenzabweichung nicht mehr tolerabel. Dies gilt beispielsweise für Anwendungen im Funktelefonbereich (GSM) und für die Satellitennavigation (GPS). Es ist daher bekannt, für diese Anwendungszwecke besonders hochwertige Oszillatoren einzusetzen, die temperaturkompensiert sind (TCXO). Diese sind allerdings sehr teuer und stellen einen merklichen Kostenfaktor für die zunehmend als Massenprodukte gefertigten Geräte dar.

Der vorliegenden Erfindung liegt die Problemstellung zugrunde, den Einsatz der teuren Spezialoszillatoren möglichst zu vermeiden.

Ausgehend von dieser Problemstellung ist eine Schaltungsanordnung der eingangs erwähnten Art erfindungsgemäß dadurch gekennzeichnet, daß mit dem Mikroprozessor ein Temperaturfühler verbunden ist, daß in dem Speicher Koeffizienten zur Bildung eines Frequenzfehlerpolynoms in Abhängigkeit von der Temperatur speicherbar sind, daß der Mikroprozessor so programmiert ist, daß er ein für die aktuelle Temperatur geltendes Frequenzfehlersignal mit Hilfe der abgespeicherten Koeffizienten bildet und daß eine Vergleichseinrichtung die Oszillatorfrequenz unter Berücksichtigung des Frequenzfehlersignals mit der aus dem Signal ermittelten Referenzfrequenz vergleicht und mittels für verschiedene Temperaturwerte erhaltener Vergleichswerte die abgespeicherten Koeffizienten des Frequenzfehlerpolynoms überprüft und ggfs. korrigiert.

Die Erfindung beruht auf der Erkenntnis, daß es für die Erstellung von Massenprodukten möglich ist, preiswerte Oszillatoren, beispielsweise einfache Quarzoszillatoren, zu verwenden, deren Temperaturfehler durch ein abgespeichertes Frequenzfehlersignal kompensiert wird. Entgegen den bisherigen Bemühungen wird daher nicht versucht, das Entstehen der Temperaturfehler durch verbesserte Oszillatoren zu vermeiden, sondern der entstehende Temperaturfehler wird in Kauf genommen und mit Hilfe eines Mikroprozessors und einer abgespeicherten Temperaturkompensation kompensiert. Die Erfindung bietet den Vorteil, daß die Verwendung einfacher Massenoszillatoren möglich ist und daß für die Durchführung der Erfindung in der Regel kein zusätzlicher Hardwareaufwand erforderlich ist, da regelmäßig mit Oszillatoren verbundene Mikroprozessoren vorgesehen sind und erfindungsgemäß ausgenutzt werden können.

Die erfindungsgemäße Schaltungsanordnung enthält ein "selbstlernendes" System, in dem eine Vergleichseinrichtung die Oszillatorfrequenz unter Berücksichtigung des Fehlerfrequenzsignals mit der aus dem Signal ermittelten Referenzfrequenz vergleicht und mittels für verschiedene Temperaturwerte erhaltener Vergleichswerte die abgespeicherten Koeffizienten des Freqenzfehlerpolynoms überprüft und ggfs. korrigiert.

Durch die abgespeicherten Koeffizienten des Frequenzfehlerpolynoms gelingt es beispielsweise bei einem GPS-Empfänger, diesen auf gesendete Signale bestimmter Satelliten abzustimmen. Die Frequenzen der von den Satelliten ausgesandten Signale sind hochstabil. Durch Feststellung etwaiger Abweichungen bei verschiedenen Temperaturen können ggfs. neue, korrigierte Koeffizienten des Frequenzfehlerpolynoms festgestellt und abgespeichert werden. Auf diese Weise gelingt es nicht nur, einen etwaigen Korrekturbedarf für die (regelmäßig aus Erfahrungswerten) abgespeicherten Koeffizienten des Frequenzfehlerpolynoms zu ermitteln, sondern auch automatisch sonstigen Einflüssen auf die Ausgangsfrequenz des Oszillators zu folgen, insbesondere die Alterung des Oszillators zu kompensieren.

Dabei ist es in den meisten Anwendungsfällen möglich, das Frequenzfehlersignal des Mikroprozessors lediglich als Korrektursignal für eine Auswertungseinrichtung zu verwenden. In manchen Anwendungsfällen (insbesondere GSM) ist es jedoch zweckmäßig, wenn der Oszillator in seiner Frequenz steuerbar ist und wenn das Frequenzfehlersignal als Regelsignal auf den Oszillator gelangt, so daß das Ausgangssignal des Oszillators temperaturkompensiert ist.

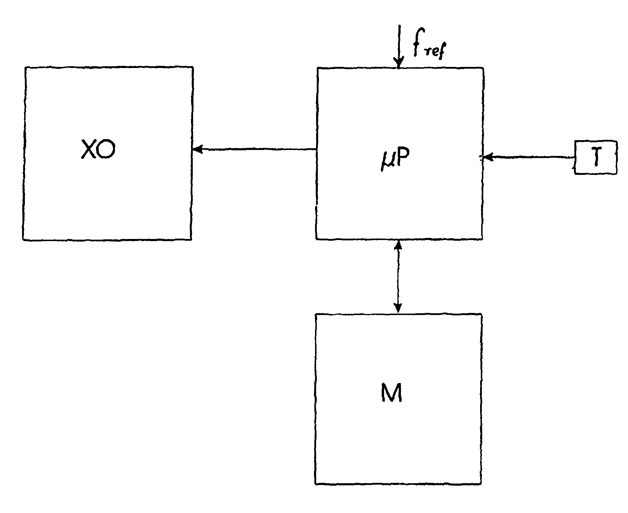

Die Erfindung soll im folgenden anhand von in der Zeichnung dargestellten Ausführungsbeispielen näher erläutert werden.

Die Zeichnung zeigt einem Oszillator XO mit dem ein Mikroprozessor µP verbunden ist. Dem Mikroprozessor µP werden Ausgangssignale eines Temperatursensors zugeführt.

Der Mikroprozessor µP kann auf einen Speicher M zugreifen, aus dem er Koeffizienten eines Frequenzfehlerpolynoms erhält.

Das Frequenzfehlerpolynom gibt die Abhängigkeit des Frequenzfehlers $\Delta f$ von der Temperatur T, bezogen auf eine Ausgangstemperatur $T_0$ (beispielsweise 20° C), wieder. Als Polynom angenähert ergibt sich:

$$\Delta f = c_0 + c_1\,(T-T_0) + c_2\,(T-T_0)^2 + c_3\,(T-T_0)^3 + c_4\,(T-T_0)^4 + \ldots \; .$$

Die zu einem bestimmten Quarzoszillator XO gehörenden Koeffizienten sind in dem Speicher M abgespeichert. Mit Hilfe des Temperatursensors T und des Prozessors $\mu$P kann der Fehler $\Delta f$ vorhergesagt werden.

In bestimmten Anwendungsfällen ist es ausreichend, daß dieser Fehler $\Delta f$ bekannt ist, da er in der Auswertung berücksichtigt werden kann. Bei anderen Systemen muß eine Korrektur der Quarzfrequenz vorgenommen werden. Dies kann erreicht werden, wenn der Quarzoszillator XO als beispielsweise spannungsgesteuerter Quarzoszillator VCXO ausgeführt ist und dieser vom Prozessor gesteuert wird (über einen Digital-Analog-Wandler).

Durch die Alterung des Quarzoszillators XO kann ein Restfehler $\Delta f_r$ bestehen.

Erfindungsgemäß ist der Mikroprozessor $\mu$P Teil eines Empfangssystems, das ein Empfangssignal aufnimmt, das eine stabile und genaue Referenzfrequenz $f_{ref}$ enthält. Der Mikroprozessor kann das Ausgangssignal des Oszillators XO unter Berücksichtigung der Korrektur mit Hilfe der Koeffizienten aus dem Speicher M mit der Referenzfrequenz $f_{ref}$ vergleichen und aus dem Vergleich für verschiedene Temperaturen des Temperatursensors T ein korrigiertes Frequenzfehlerpolynom berechnen, so daß die im Speicher M abgespeicherten Koeffizienten vom Mikroprozessor $\mu$P korrigiert werden.

Diese automatische Korrektur führt zu einer automatischen Berücksichtigung des Alterungsverhaltens des Oszillators XO, also zu einer automatische Beseitigung des durch die Alterung des Quarzoszillators XO hervorgerufenen Restfehlers $\Delta f_r$. Darüber hinaus ist es in diesem Fall ausreichend, die im Speicher M abgespeicherten Koeffizienten nur ungefähr zu ermitteln, beispielsweise als mittlere Koeffizienten einer Fertigungscharge von Quarzoszillatoren, da Streuungen des Quarzes durch das Korrekturvermögen des Mikroprozessors $\mu$P für die im Speicher M abgespeicherten Koeffizienten etwaigen Streuungsabweichungen Rechnung getragen werden kann.

Demgemäß kann bei diesem Verfahren der Abgleich des Quarzoszillators XO in der Fertigung entfallen. Es reicht aus, den Frequenzfehler bei $T_0$ zu messen und den Koeffizienten $c_0$ abzuspeichern.

Selbstverständlich ist die beschriebene Erfindung nicht nur auf Quarzoszillatoren, sondern auf alle Oszillatoren anwendbar.

**Patentansprüche**

1. Schaltungsanordnung mit einem Mikroprozessor ($\mu$P), einem Speicher (M) und einem Oszillator (XO) zur Erzeugung eines Frequenzsignals hoher Genauigkeit sowie mit einer Empfangseinrichtung für ein eine genaue Referenzfrequenz ($f_{ref}$) enthaltendes Signal, **dadurch gekennzeichnet, daß** mit dem Mikroprozessor ($\mu$P) ein Temperaturfühler (T) verbunden ist, daß in dem Speicher (M) Koeffizienten zur Bildung eines Frequenzfehlerpolynoms in Abhängigkeit von der Temperatur speicherbar sind, daß der Mikroprozessor ($\mu$P) so programmiert ist, daß er ein für die aktuelle Temperatur geltendes Frequenzfehlersignal mit Hilfe der abgespeicherten Koeffizienten bildet und daß eine Vergleichseinrichtung die Oszillatorfrequenz unter Berücksichtigung des Frequenzfehlersignals mit der aus dem Signal ermittelten Referenzfrequenz ($f_{ref}$) vergleicht und mittels für verschiedene Temperaturwerte erhaltener Vergleichswerte die abgespeicherten Koeffizienten des Frequenzfehlerpolynoms überprüft und ggfs. korrigiert.

2. Schaltungsanordnung nach Anspruch 1, **dadurch gekennzeichnet, daß** das Frequenzfehlersignal des Mikroprozessors ($\mu$P) eine Auswertungseinrichtung steuert.

3. Schaltungsanordnung nach Anspruch 1, **dadurch gekennzeichnet, daß** der Oszillator (XO) in seiner Frequenz steuerbar ist und daß das Frequenzfehlersignal als Regelsignal auf den Oszillator (XO) gelangt.

4. Schaltungsanordnung nach einem der Ansprüche 1 bis 3, **dadurch gekennzeichnet, daß** die Empfangseinrichtung zum Empfang von die Referenzfrequenz ($f_{ref}$) enthaltenden Satellitensignalen ausgebildet ist.

5. Schaltungsanordnung nach Anspruch 4, **dadurch gekennzeichnet, daß** die empfangenen Satellitensignale Satelliten-Navigationssignale, insbesondere GPS-Signale, sind.

6. Schaltungsanordnung nach Anspruch 3, **dadurch gekennzeichnet, daß** der Oszillator (XO) Teil eines GSM-Telefonapparats ist.

**Claims**

1. Circuit arrangement having a microprocessor (μP), a memory (M) and an oscillator (XO) for generating a high-precision frequency signal, and having a receiver device for a signal containing a precise reference frequency ($f_{ref}$), **characterized in that** a temperature sensor (T) is connected to the microprocessor (μP), **in that** coefficients for forming a frequency error polynomial as a function of the temperature can be stored in the memory (M), **in that** the microprocessor (μP) is programmed in such a way that it uses the stored coefficients to form a frequency error signal which applies for the current temperature, and **in that** a comparator device compares the oscillator frequency with the reference frequency ($f_{ref}$) determined from the signal, taking into account the frequency error signal and checks and, if appropriate, corrects the stored coefficients of the frequency error polynomial by means of comparison values obtained for various temperature values.

2. Circuit arrangement according to Claim 1, **characterized in that** the frequency error signal of the microprocessor (μP) controls an evaluation device.

3. Circuit arrangement according to Claim 1, **characterized in that** the frequency of the oscillator (XO) can be controlled, and **in that** the frequency error signal is fed as a control signal to the oscillator (XO).

4. Circuit arrangement according to one of Claims 1 to 3, **characterized in that** the receiver device is designed to receive satellite signals containing the reference frequency ($f_{ref}$).

5. Circuit arrangement according to Claim 4, **characterized in that** the received satellite signals are satellite navigation signals, in particular GPS signals.

6. Circuit arrangement according to Claim 3, **characterized in that** the oscillator (XO) is part of a GSM telephone apparatus.

**Revendications**

1. Circuit comprenant un microprocesseur (μP), une mémoire (M) et un oscillateur (XO) pour générer un signal de fréquence de grande précision ainsi qu'une installation de réception pour un signal contenant une fréquence de référence précise ($f_{ref}$),
   **caractérisé en ce qu'**
   un capteur de température (T) est relié au microprocesseur (μP),
   la mémoire (M) contient les coefficients pour former un polynôme d'erreur de fréquence en fonction de la température,
   le microprocesseur (μP) est programmé pour former un signal d'erreur de fréquence valable pour la température actuelle, en utilisant les coefficients mis en mémoire et, une installation de comparaison compare la fréquence de l'oscillateur en tenant compte du signal d'erreur de fréquence à la fréquence de référence ($f_{ref}$) obtenue à partir du signal, et à l'aide de valeurs de comparaison correspondant à différentes valeurs de température, on contrôle ou le cas échéant on corrige les coefficients mémorisés du polynôme d'erreur de fréquence.

2. Circuit selon la revendication 1,
   **caractérisé en ce que**
   le signal d'erreur de fréquence du microprocesseur (μP) commande une installation de traitement.

3. Circuit selon la revendication 1,
   **caractérisé en ce que**
   l'oscillateur (XO) est commandé en fréquence et le signal d'erreur de fréquence est appliqué comme signal de régulation à l'oscillateur (XO).

4. Circuit selon l'une quelconque des revendications 1 à 3,
   **caractérisé en ce que**
   l'installation de réception est conçue pour recevoir des signaux de satellite contenant la fréquence de référence ($f_{ref}$).

5. Circuit selon la revendication 4,

**caractérisé en ce que**
les signaux de satellite reçus sont des signaux de navigation par satellite notamment des signaux GPS.

6. Circuit selon la revendication 3,
   **caractérisé en ce que**
   l'oscillateur (XO) fait partie d'un appareil téléphonique du système GSM.

$f_{ref}$

| XO | ← | $\mu P$ | ← | T |

M